# EUROPEAN PATENT SPECIFICATION

(11) **EP 2 943 803 B1**
(45) Date of publication and mention of the grant of the patent: **07.06.2017**
(21) Application number: 13811184.4
(22) Date of filing: 17.12.2013
(51) Int. Cl.: G01R 31/04, G01R 31/28, G06F 11/263, G01R 31/319, G06F 9/30, G06F 11/22, G06F 11/30

(54) **MICROCONTROLLER ANALYSIS TOOLS**
ANALYSEINSTRUMENTE FÜR MIKROSTEUERUNG
OUTILS D'ANALYSE DE MICROCONTRÔLEUR

(30) Priority: 09.01.2013 GB 201300366
(43) Date of publication of application: 18.11.2015
(73) Proprietor: Nordic Semiconductor ASA, 7004 Trondheim (NO)
(72) Inventor: RUSTEN, Joar, Olai, 7004 Trondheim (NO)
(74) Representative: Samuels, Adrian James
(86) International application number: PCT/EP2013/076854
(87) International publication number: WO 2014/108279

(56) References cited:
- US-A- 4 760 330
- US-A- 5 909 450
- US-A1- 2010 313 092

## Description

This invention relates to tools which may be used by those who wish to ascertain or test the functioning of a digital microcontroller such as application developers, product developers, testers and the like.

It is common for the manufacturers of microcontroller unit integrated circuits ("MCU chips") to provide a software development kit which allows those purchasing the chips to develop software applications which utilise the chip. These would normally comprise peripheral components such as a power supply, user interface etc which can simulate an environment in which the chip would be employed in a product. An important aspect of developing an application for an MCU to be used in a product, particularly one which is to be battery-powered, is to seek to optimise the use of power. Thus one of the things that a development kit is used for is to measure the current consumption of the chip during various modes of operation. US 2010/0313092 discloses techniques for efficiently introducing instructions and data for core functional pattern tests when testing processor integrated circuits.

It is also common to provide MCU chips with a debugger function in which extensive operational information is provided by the chip via a dedicated pin which can be connected to a compatible debugger tool. Some manufacturers have integrated such a debugger tool with a development kit.

However the Applicant would like to enhance the ease and reliability with which developers can explore and test the functions of MCU chips and when viewed from a first aspect the invention provides a device for analyzing the behaviour of a microcontroller, the device being configured to receive a microcontroller integrated circuit, wherein the device comprises:
at least one instrument selected from the group comprising analyzers and generators;
an interconnection module comprising configurable interconnections between, in use, said microcontroller integrated circuit and said instrument; and
software arranged to control said interconnection module in order to determine said interconnections based on a function selected by a user and determined capabilities and connections of the microcontroller integrated circuit.

Thus it will be seen by those skilled in the art that in accordance with the invention a tool is provided which, in at least its preferred embodiments, allows a user to analyze the behaviour of an MCU chip using standard instruments without the user needing to know or remember the detailed configuration, particularly the pin layout, of the MCU nor indeed that of the instrument(s).

The analyzer may be selected from the group comprising: logic analyzers, oscilloscopes, spectrum analyzers, current measurement devices, pattern and bus decoders and pattern and bus analyzers. The generator may be selected from the group comprising signal generators and pattern generators. These groups are to be considered non-limiting and any other analyzers or generators could be used. The apparatus of the invention may comprise one or more instruments. Where more than one is provided they may comprise at least one generator and at least one analyzer but this is not essential.

The instruments exemplified above tend to be standard instruments which can be used for analysis of a variety of MCU chips. However by contrast with the prior art where it would be necessary for the user to be aware of the detailed operation of the instrument and the pin layout of the MCU chip in order to ensure proper connection for a given operation to be carried out, in accordance with the invention the connections between then can be handled by the interconnection module. Even in circumstances where the user is familiar with the MCU pin layout and the configurations of the instrument probes, embodiments of the invention allow experimental set-ups to be implemented more quickly and with less risk of making a mistake.
Some or all of the capabilities and connections are determined by the device itself. For example the device may comprise software arranged to interrogate the microcontroller integrated circuit to find out how the resources inside it are configured, and/or at which input/output addresses the resources are mapped. This allows the resources to be presented to a user with options as to how the resources are connected to the analyzer/generator.

The instrument need not be connected just to one microcontroller integrated circuit, it could be connected to a plurality thereof - e.g. via a multiplexing arrangement such as a time-multiplexing arrangement. This may allow for more efficient utilisation of a given instrument. It may also allow for comparative tests between MCU chips which are similar or nominally identical.

In a set of embodiments the interconnection module comprises a field-programmable gate array (FPGA).

The device may comprise a user interface to allow a user located at the device to operate the software locally. However this is not essential. It is also envisaged that a remote user could operate the software via a suitable data network link such that it is not necessary for a developer to have physical possession of the MCU chip. This also facilitates collaborative working.

As well as configuring the interconnections between the microcontroller integrated circuit and the instrument the device may also be arranged to configure the operation of the instrument or one or more of the instruments. Thus, for example, where a particular operation mode or resources have been determined for the microcontroller integrated circuit, the instrument may be connected suitably to probe that resource and may also be configured suitably for such an operation. Configuration of the instrument(s) may be carried out automatically based on the capabilities of the microcontroller integrated circuit. For example where the microcontroller integrated circuit's serial peripheral interface (SPI) is connected to an SPI pattern generator, the SPI pattern generator may be configured automatically with the correct data rate and operation mode for this.

In a set of embodiments the device is arranged to store data relating to settings of the interconnection module and/or the instrument in order that these can be reused at a later date or on another device etc.

When viewed from third aspect the invention provides a computer software product, which may or may not be provided on a carrier, the software being configured when run on a suitable data processor to control an interconnection module having configurable interconnections between a microcontroller integrated circuit and at least one instrument selected from the group comprising analyzers and generators in order to determine said interconnections based on a function selected by a user and determined capabilities and connections of the microcontroller integrated circuit.

An embodiment of the invention will now be described, by way of example only, with reference to the accompanying drawings in which:
- Fig. 1: is a schematic overview of a device embodying the invention;
- Fig. 2: is a more detailed schematic diagram of the hardware of the device; and
- Fig. 3: is an exemplary screen-shot of the device's user interface.

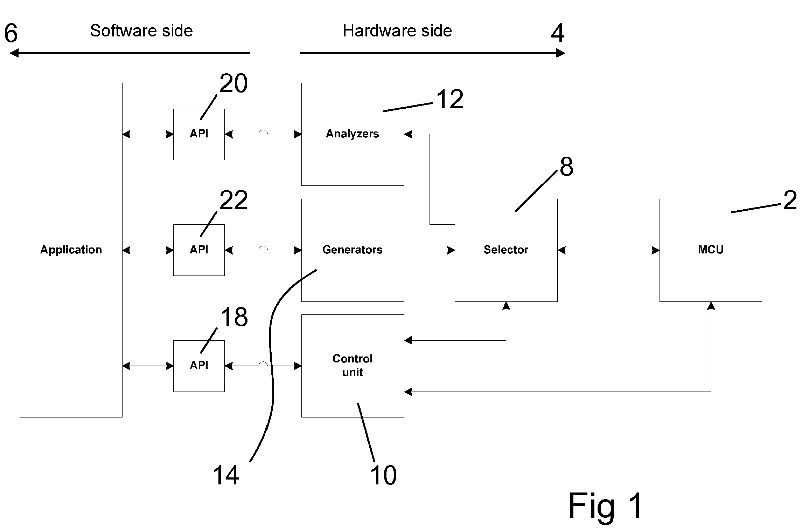

Fig. 1 is schematic overview of a device embodying the invention for analysing the functions of a microprocessor integrated circuit (MCU) 2. It may be seen that the device comprises a hardware side 4 including the MCU, and a software side 6. The MCU 2 is connected to selectively configurable interconnection module 8 which will hereinafter be referred to as a 'selector'. The MCU 2 and selector 8 are also connected a control unit 10. Two exemplary instruments for use in the analysis of the MCU 2 are provided: namely an analyzer 12 and a generator 14. The analyzer 12 is used to examine and record the outputs of the MCU 2 and thus receives these outputs via the selector 8. The generator 14 is used to generate suitable signals or patterns for inputting into the MCU 2 and thus provides these inputs to the selector 8.

On the software side 6 an overall software application 16 is provided which communicates with the control unit 10, analyzer 12 and generator 14 by means of respective application peripheral interfaces 18, 20, 22.

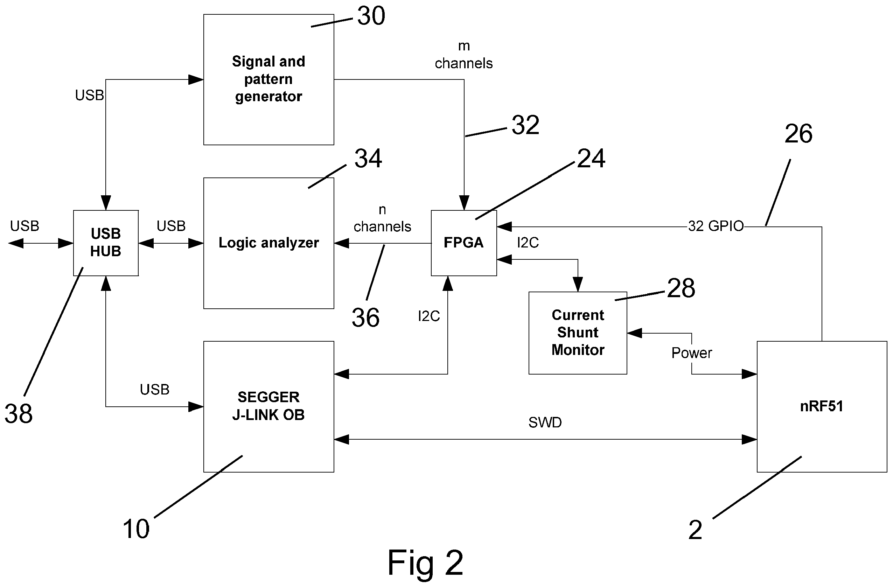

The hardware components are shown in a little more detail in Fig. 2. On the right hand side of the diagram is shown the MCU 2 which is exemplified here as one of the Applicant's nRF51 range of chips, although of course any other suitable MCU could be used. The MCU 2 is connected to a Field Programmable Gate Array (FPGA) 24 by means of thirty two general purpose input/output connections 26.

The power to the MCU 2 is provided by the FPGA 24 by means of a current shunt monitor 28 which allows the current drawn by the MCU 2 at any given moment to be measured. The FPGA 24 and the current shunt monitor 28 together comprise the selector 8 of Fig. 1.

As previously described the MCU 2 is also connected to the control unit 10 in order for its operation to be controlled. In one exemplary embodiment the control unit 10 is provided by a J-Link emulator tool available from Segger Microcontroller GmbH & Co. KG in Hilden, Germany. The control unit also provides control of the FPGA 24.

In this particular detailed example the generator is exemplified as a signal and pattern generator 30, for example the Cypress EZ-USB FX3, which provides outputs 32 on a number of channels to the FPGA 24. The analyzer exemplified here is a logic analayzer 34, which can also be provided by the Cypress EZ-USB FX3 and which has a number of input channels 36 connected to the FPGA 24.

The signal and pattern generator 30, the logic analyzer 34 and the control unit 10 are connected to a USB hub 38 which provides a common connection to the application software 16 operating the device.

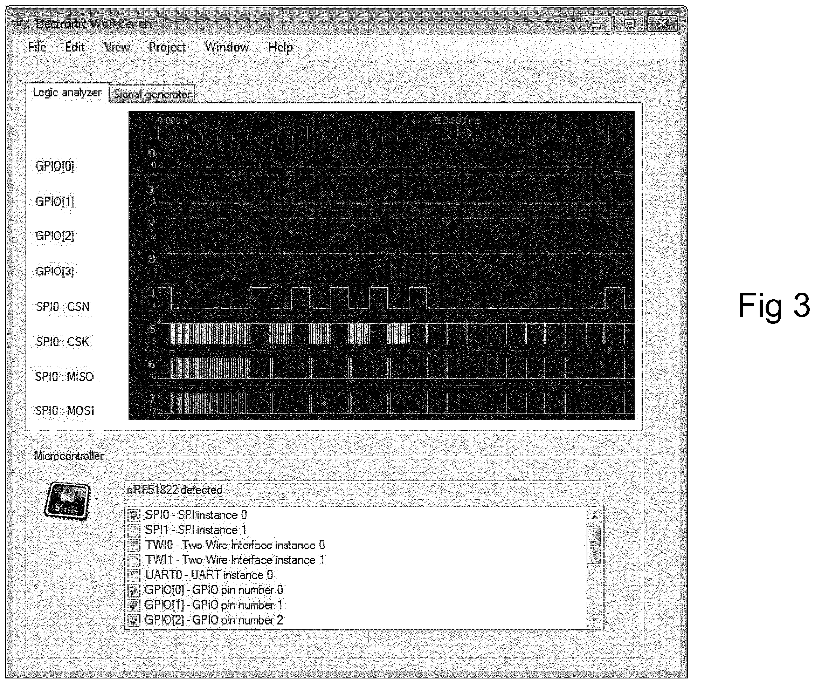

In use the software application 16 detects what sort of microcontroller is present in the device (e.g. say nRF51822) by accessing the MCU 2 via the control unit 10. This information may be displayed on a user interface provided by the software 16 as is illustrated by the "nRF51822 detected" in the box in the lower half of the screen-shot shown in Fig. 3. Detecting the type of microcontroller allows the software application to set the device up. This can be done e.g. using information in a library or downloaded from a server. However the software application 16 may instead set up the device by interacting with the control unit 10 to query the MCU 2 to find out how the different resources inside the MCU 2 are configured and at which input/outputs 26 these resources are mapped. Either way the software application 16 can command the control unit 10 to control the FPGA 24 to set up the proper interconnections in order to present the MCU's resources to the user with options on how they can be connected to the logic analyzer 34 and the signal and pattern generator 30. Fig. 3 shows the connections available for selection by the check-boxes in the lower window.

When the user has specified such a connection the software application 16 then configures the FPGA 24 appropriately to connect these resources to the correct input/outputs 26 on the MCU 2 according to the user's preference. This infrastructure enables the software application to fully abstract away the probe interconnect details between the analyzer 34 and the generator 30, and how these are connected to the MCU 2 without having to expose any of them to the user.

The software application 16 can then instead provide a very simple interface to the user as shown in Fig. 3 showing how the analyzers and the generators can be connected to the appropriate resources on the MCU 2. It is also possible for the software application 16 to simplify the setup of the analyzer 34 and the generator 30 since detailed information about how the MCU 2 is configured is available to the software application 16. Such setup of the instruments 30, 34 is carried out using the data connection provided by the USB hub 38. For example if the MCU's serial peripheral interface (SPI) is connected to the pattern generator 30, the latter can be configured automatically with the correct data rate and operation mode etc.

The advantages provided by the embodiment described above can be appreciated by comparing it with a typical scenario for setting up a workbench in the prior art. There it would be necessary manually to connect probe number X on the generator to probe number Y on the analyzer and then connect this to pin number Z on the MCU. The user would then have to set up the generator and the analyzer to match the settings of the resource that is being probed on the MCU, and ensure that the particular resource on the MCU is running correctly and connected to the correct pin and probe etc.

By contrast in accordance with the embodiment described above such a workbench setup is considerably simplified since the software application knows how the different components in the device are interconnected and configured. Analyzer and generator probe interconnections with the MCU can be set up automatically based on information extracted from the MCU and from information provided by the user via the software application. Analyzers and generators can also be configured automatically based on the same information.

Since the embodiment described does not require any interconnections to be handled manually, and since it is controlled by software, several advantages are gained compared to using a traditional workbench setup. First errors are less likely to be introduced. Second less work is required to set up new workbenches. Moreover once completed, the work carried out in setting up can be re-used by saving a setup's configuration in a configuration file and reapplying it later. This also means that a setup configuration file can be used to analyze the setup without having access to the hardware. Furthermore a setup can be connected to a virtual portal and accessed by a remote agent; and one instrument (generator or analyzer) can be employed in several places at the same time using time multiplexing is possible.

It will be appreciated by those skilled in the art that the embodiment described above is merely exemplary and that many details may be changed within the scope of the invention. For example additional or different instruments may be employed and of course it may be used with different microcontrollers.

## Claims

1. A device for analyzing the behaviour of a microcontroller, the device being configured to receive a microcontroller integrated circuit (2), wherein the device comprises:
at least one instrument selected from the group comprising analyzers (12) and generators (14);
an interconnection module (8) comprising configurable interconnections between, in use, said microcontroller integrated circuit (2) and said instrument; and
software (16) arranged to control said interconnection module (8) in order to determine said interconnections based on a function selected by a user and determined capabilities and connections of the microcontroller integrated circuit (2), **characterised in that** the device is itself configured to determine at least some capabilities and connections of the microcontroller integrated circuit (2).

2. A device as claimed in claim 1 wherein the device comprises the microcontroller integrated circuit (2).

3. A device as claimed in claim 1 wherein the generator (14) is selected from the group comprising signal generators and pattern generators.

4. A device as claimed in any preceding claim arranged to interrogate the microcontroller integrated circuit (2) to find out how resources inside it are configured, and/or at which input/output addresses the resources are mapped.

5. A device as claimed in any preceding claim wherein the interconnection module comprises a field-programmable gate array (24).

6. A device as claimed in any preceding claim arranged to configure the operation of the instrument or one or more of the instruments.

7. A device as claimed in any preceding claim arranged to carry out said configuration automatically based on the capabilities of the microcontroller integrated circuit (2).

8. A device as claimed in any preceding claim arranged to store data relating to settings of the interconnection module (8) and/or the instrument.

9. A computer software product configured when run on a data processor to control an interconnection module (8) having configurable interconnections between a microcontroller integrated circuit (2) and at least one instrument selected from the group comprising analyzers (12) and generators (14) in order to determine said interconnections based on a function selected by a user and determined capabilities and connections of the microcontroller integrated circuit (2), **characterised in that** the computer software product is further configured to determine at least some capabilities and connections of the microcontroller integrated circuit (2).

10. A device as claimed in any of claims 1 to 8 or a software product as claimed in claim 9 wherein the analyzer (12) is selected from the group comprising: logic analyzers, oscilloscopes, spectrum analyzers, current measurement devices, pattern and bus decoders and pattern and bus analyzers.

11. A software product as claimed in claim 9 or 10 wherein the generator (14) is selected from the group comprising signal generators and pattern generators.

12. A software product as claimed in any of claims 9 to 11 configured to interrogate the microcontroller integrated circuit (2) to find out how resources inside it are configured, and/or at which input/output addresses the resources are mapped.

13. A software product as claimed in any of claims 9 to 12 comprising logic arranged to configure the operation of the instrument or one or more of the instruments,

14. A software product as claimed in any of claims 9 to 13 comprising logic arranged to carry out said configuration automatically based on the capabilities of the microcontroller integrated circuit (2).

15. A software product as claimed in any of claims 9 to 14 configured to store data relating to settings of the interconnection module (8) and/or the instrument.

## Patentansprüche

1. Vorrichtung zur Analyse des Verhaltens eines Mikrocontrollers, wobei die Vorrichtung dazu konfiguriert ist, eine integrierte Mikrocontroller-Schaltung (2) aufzunehmen, wobei die Vorrichtung aufweist:
mindestens ein Instrument, das aus der Gruppe ausgewählt ist, die Analysatoren (12) und Generatoren (14) aufweist;
ein Verschaltungsmodul (8), das konfigurierbare Verschaltungen zwischen, in Verwendung, der integrierten Mikrocontroller-Schaltung (2) und dem Instrument aufweist; und
Software (16), die dazu eingerichtet ist, das Verschaltungsmodul (8) zu steuern, um die Verschaltungen basierend auf eine durch einen Benutzer ausgewählte Funktion und bestimmten Fähigkeiten und Verbindungen der integrierten Mikrocontroller-Schaltung (2) zu bestimmen, **dadurch gekennzeichnet, dass** die Vorrichtung selbst dazu konfiguriert ist, mindestens einige Fähigkeiten und Verbindungen der integrierten Mikrocontroller-Schaltung (2) zu bestimmen.

2. Vorrichtung nach Anspruch 1, wobei Vorrichtung die integrierte Mikrocontroller-Schaltung (2) aufweist.

3. Vorrichtung nach Anspruch 1, wobei der Generator (14) aus der Gruppe ausgewählt ist, die Signalgeneratoren und Mustergeneratoren aufweist.

4. Vorrichtung nach einem der vorhergehenden Ansprüche, die dazu eingerichtet ist, die integrierte Mikrocontroller-Schaltung (2) abzufragen, um herauszufinden, wie Ressourcen in ihr konfiguriert sind und/oder auf welche Eingabe-/Ausgabe-Adressen die Ressourcen abgebildet werden.

5. Vorrichtung nach einem der vorhergehenden Ansprüche, wobei das Verschaltungsmodul ein feldprogrammierbares Gate-Array (24) aufweist.

6. Vorrichtung nach einem der vorhergehenden Ansprüche, die dazu eingerichtet ist, den Betrieb des Instruments oder eines oder mehrerer der Instrumente zu konfigurieren.

7. Vorrichtung nach einem der vorhergehenden Ansprüche, die dazu eingerichtet ist, die Konfiguration automatisch basierend auf den Fähigkeiten der integrierten Mikrocontroller-Schaltung (2) durchzuführen.

8. Vorrichtung nach einem der vorhergehenden Ansprüche, die dazu eingerichtet ist, Daten zu speichern, die sich auf Einstellungen des Verschaltungsmoduls (8) und/oder des Instruments beziehen.

9. Computersoftwareprodukt, das dazu konfiguriert ist, wenn es auf einem Datenprozessor ausgeführt wird, ein Verschaltungsmodul (8) mit konfigurierbaren Verschaltungen zwischen einer integrierten Mikrocontroller-Schaltung (2) und mindestens einem Instrument, ausgewählt aus der Analysatoren (12) und Generatoren (14) aufweisenden Gruppe, zu steuern, um die Verschaltungen basierend auf einer durch einen Benutzer ausgewählten Funktion und bestimmten Fähigkeiten und Verbindungen der integrierten Mikrocontroller-Schaltung (2) zu bestimmen, **dadurch gekennzeichnet, dass** das Computersoftwareprodukt ferner dazu konfiguriert ist, zumindest einige Fähigkeiten und Verbindungen der integrierten Mikrocontroller-Schaltung (2) zu bestimmen.

10. Vorrichtung nach einem der Ansprüche 1 bis 8 oder Softwareprodukt nach Anspruch 9, wobei der Analysator (12) aus der Gruppe ausgewählt ist, die aufweist: Logikanalysatoren, Oszilloskope, Spektrumanalysatoren, Strommessgeräte, Muster- und Busdecoder, und Muster- und Busanalysatoren.

11. Softwareprodukt nach Anspruch 9 oder 10, wobei der Generator (14) aus der Gruppe ausgewählt ist, die Signalgeneratoren und Mustergeneratoren aufweist.

12. Softwareprodukt nach einem der Ansprüche 9 bis 11, das dazu konfiguriert ist, die integrierte Mikrocontroller-Schaltung (2) abzufragen, um herauszufinden, wie Ressourcen in ihr konfiguriert sind und/oder auf welche Eingabe-/Ausgabe-Adressen die Ressourcen abgebildet werden.

13. Softwareprodukt nach einem der Ansprüche 9 bis 12, aufweisend eine Logik, die dazu eingerichtet ist, den Betrieb des Instruments oder eines oder mehrerer der Instrumente zu konfigurieren.

14. Softwareprodukt nach einem der Ansprüche 9 bis 13, aufweisend eine Logik, die dazu eingerichtet ist, die Konfiguration automatisch basierend auf den Fähigkeiten der integrierten Mikrocontroller-Schaltung (2) auszuführen.

15. Softwareprodukt nach einem der Ansprüche 9 bis 14, das dazu konfiguriert ist, Daten zu speichern, die sich auf Einstellungen des Verschaltungsmoduls (8) und/oder des Instruments beziehen.

## Revendications

1. Dispositif d'analyse du comportement d'un microcontrôleur, le dispositif étant configuré pour recevoir un circuit intégré de microcontrôleur (2), le dispositif comprend :
au moins un instrument choisi dans le groupe comprenant des analyseurs (12) et des générateurs (14) ;
un module d'interconnexion (8) comprenant des interconnexions configurables entre, en utilisation, ledit circuit intégré de microcontrôleur (2) et ledit instrument ; et
un logiciel (16) conçu pour contrôler ledit module d'interconnexion (8) afin de déterminer lesdites interconnexions sur la base d'une fonction choisie par un utilisateur et de capacités et connexions déterminées du circuit intégré de microcontrôleur (2), **caractérisé en ce que** le dispositif est lui-même configuré pour déterminer au moins certaines capacités et connexions du circuit intégré de microcontrôleur (2).

2. Dispositif selon la revendication 1, dans lequel le dispositif comprend le circuit intégré de microcontrôleur (2).

3. Dispositif selon la revendication 1, dans lequel le générateur (14) est choisi dans le groupe comprenant des générateurs de signaux et des générateurs de modèles.

4. Dispositif selon une quelconque revendication précédente conçu pour interroger le circuit intégré de microcontrôleur (2) pour découvrir comment les ressources à l'intérieur de celui-ci sont configurées, et/ou sur quelles adresses d'entrée/de sortie les ressources sont mappées.

5. Dispositif selon une quelconque revendication précédente, dans lequel le module d'interconnexion comprend un réseau prédiffusé programmable par l'utilisateur (24).

6. Dispositif selon une quelconque revendication précédente conçu pour configurer le fonctionnement de l'instrument ou d'un ou plusieurs des instruments.

7. Dispositif selon une quelconque revendication précédente conçu pour réaliser ladite configuration automatiquement sur la base des capacités du circuit intégré de microcontrôleur (2).

8. Dispositif selon une quelconque revendication précédente conçue pour stocker des données relatives à des réglages du module d'interconnexion (8) et/ou de l'instrument.

9. Produit logiciel informatique configuré lorsqu'il est exécuté sur une machine de traitement des données pour contrôler un module d'interconnexion (8) ayant des interconnexions configurables entre un circuit intégré de microcontrôleur (2) et au moins un instrument choisi dans le groupe comprenant des analyseurs (12) et des générateurs (14) afin de déterminer lesdites interconnexions sur la base d'une fonction choisie par un utilisateur et des capacités et connexions déterminées du circuit intégré de microcontrôleur (2), **caractérisé en ce que** le produit logiciel informatique est en outre configuré pour déterminer au moins certaines capacités et connexions du circuit intégré de microcontrôleur (2).

10. Dispositif selon l'une quelconque des revendications 1 à 8 ou produit logiciel selon la revendication 9 dans lequel l'analyseur (12) est choisi dans le groupe comprenant :
des analyseurs de logique, des oscilloscopes, des analyseurs de spectre, des dispositifs de mesure de courant, des décodeurs de modèles et de bus et des analyseurs de modèles et de bus.

11. Produit logiciel selon la revendication 9 ou 10, dans lequel le générateur (14) est choisi dans le groupe comprenant des générateurs de signaux et des générateurs de modèles.

12. Produit logiciel selon l'une quelconque des revendications 9 à 11 configuré pour interroger le circuit intégré de microcontrôleur (2) pour découvrir comment les ressources à l'intérieur de celui-ci sont configurées, et/ou sur quelles adresses d'entrée/de sortie les ressources sont mappées.

13. Produit logiciel selon l'une quelconque des revendications 9 à 12 comprenant une logique conçue pour configurer le fonctionnement de l'instrument ou d'un ou plusieurs des instruments.

14. Produit logiciel selon l'une quelconque des revendications 9 à 13 comprenant une logique conçue pour réaliser ladite configuration automatiquement sur la base des capacités du circuit intégré de microcontrôleur (2).

15. Produit logiciel selon l'une quelconque des revendications 9 à 14 configuré pour stocker des données relatives à des réglages du module d'interconnexion (8) et/ou de l'instrument.
